# EUROPÄISCHE PATENTSCHRIFT

(11) **EP 2 721 693 B1**
(45) Veröffentlichungstag und Bekanntmachung des Hinweises auf die Patenterteilung: **11.04.2018**
(21) Anmeldenummer: 12738024.4
(22) Anmeldetag: 13.06.2012
(51) Int. Cl.: G01R 1/04, H01R 9/24, H01R 9/26

(54) **ELEKTRISCHES VERBINDUNGSMODUL MIT UNTERBRECHBAREM STROMKREIS**
ELECTRICAL CONNECTING MODULE WITH AN INTERRUPTIBLE CIRCUIT
MODULE DE RACCORDEMENT ÉLECTRIQUE COMPORTANT UN CIRCUIT POUVANT ÊTRE INTERROMPU

(30) Priorität: 17.06.2011 DE 102011105157
(43) Veröffentlichungstag der Anmeldung: 23.04.2014
(73) Patentinhaber: Phoenix Contact GmbH & Co. KG, 32825 Blomberg (DE)
(72) Erfinder: TOMBERS, Roland, 33102 Paderborn (DE); BECKER, Markus, 33102 Paderborn (DE)
(74) Vertreter: Patentship Patentanwaltsgesellschaft mbH
(86) Internationale Anmeldenummer: PCT/EP2012/002498
(87) Internationale Veröffentlichungsnummer: WO 2012/171639

(56) Entgegenhaltungen:
- EP-A1- 2 280 455
- DE-U1-202006 015 897
- GB-A- 2 065 993
- US-A1- 2002 106 926
- US-B1- 6 811 425

## Beschreibung

Die vorliegende Erfindung betrifft ein elektrisches Verbindungsmodul mit unterbrechbarem Stromkreis.

Zum Herstellen von elektrischen Verbindungen für industrielle Anwendungen werden Verbindungsmodule eingesetzt, welche beispielsweise Schraub- oder Federkraftanschlüsse bereitstellen. Derartige Verbindungsmodule umfassen üblicherweise mehrere Modulelemente mit Leitungsanschlüssen, beispielsweise mit Schraub- oder Federkraftanschlüssen für die Aufnahme von elektrischen Leitungen, und können auf eine gemeinsame Tragschiene gerastet werden. Ein Beispiel für ein derartiges Verbindungsmodul ist ein analoges Modul mit Modulelementen, deren Baubreite 6,2 mm beträgt. Zur Erfassung eines elektrischen Stroms ist es jedoch notwendig, ein Strommessgerät in einen Strompfad zu schalten. Hierzu müssen bei den bekannten Verbindungsmodulen jedoch die Leitungen aus den jeweiligen Anschlusspolen entnommen werden. Dies ist insbesondere dann problematisch, wenn mehrere Modulelemente nebeneinander auf die Tragschiene gerastet oder übereinander angeordnet sind. Liegen die Anschlüsse des jeweiligen Modulelementes untereinander, so ist es notwendig, zur Entnahme einer Leitung aus dem unteren Anschluss die darüber liegende Leitung zu lösen, was mit einem erhöhten Aufwand verbunden ist. Dadurch ist der Messaufwand erhöht.

Die Druckschrift DE 20 2006 015 897 U1 betrifft ein elektrisches Gerät mit einem Gehäuse zum Aufsetzen auf eine Tragschiene. Das Gehäuse umfasst mehrere Steckanschlüsse jeweils zur Aufnahme eines einzelnen Steckverbinders.

Die Druckschrift US 6,811,425 B1 betrifft ein Steuermodul, in dem ein Verbindungssitz einer Schaltungseinheit in einem hohlen Gehäuse angeordnet ist. Das Steuermodul umfasst seitliche Aufnahmen, die einen Satz leitender Kontakte umfassen. In die Aufnahmen ist jeweils ein Anschlussblock einsetzbar.

Die Druckschrift GB 2065 993 A betrifft einen elektrischen Verbinder mit gegenseitig eingreifenden männlichen und weiblichen Teilen.

Die Druckschrift EP 2 280 455 A1 betrifft einen elektrischen kontakt mit einem zumindest teilweise zylindrischen Körper.

Die Druckschrift US 2002/0106926 A1 betrifft ein Gerät für eine im Betrieb steckbare elektronische Komponente.

Es ist daher die Aufgabe der vorliegenden Erfindung, ein elektrisches Verbindungsmodul der vorgenannten Art zu schaffen, bei dem ein Strompfad unterbrochen werden kann, ohne dass hierzu die Leitungen aus den Modulelementen entnommen werden müssen.

Diese Aufgabe wird durch die Merkmale der unabhängigen Ansprüche gelöst. Vorteilhafte Weiterbildungsformen sind Gegenstand der Beschreibung, der Zeichnungen und der abhängigen Ansprüche.

Die vorliegende Erfindung basiert auf der Erkenntnis, dass ein Strompfad auch innerhalb eines Modulelementes unterbrochen werden kann. Dadurch wird in vorteilhafter Weise erreicht, dass die Leitungen aus den Anschlusspolen des Modulelementes nicht mehr entnommen werden müssen und in den Anschlusspolen des Modulelementes verbleiben können.

Gemäß einem Aspekt betrifft die Erfindung ein elektrisches Verbindungsmodul mit einem Modulgehäuse, das ein erstes elektrisches Anschlussterminal mit einem ersten Anschlusspol und einem zweiten Anschlusspol umfasst, einem Modulelement mit einem zweiten elektrischen Anschlussterminal, das ein erstes Anschlusspol und ein zweites Anschlusspol umfasst, und mit einem dritten elektrischen Anschlussterminal, das ein erstes Anschlusspol und ein zweites Anschlusspol umfasst, und einem Prüfkanal für die Aufnahme einer Prüfspitze, wobei das erste elektrische Anschlussterminal mit dem dritten elektrischen Anschlussterminal über das zweite elektrische Anschlussterminal elektrisch verbindbar ist, wobei bei bestehender elektrischer Verbindung zwischen dem ersten Anschlusspol des ersten Anschlussterminals und dem ersten Anschlusspol des dritten Anschlussterminals die elektrische Verbindung zwischen dem zweiten Anschlusspol des ersten Anschlussterminals und dem zweiten Anschlusspol des dritten Anschlussterminals trennbar ist, und wobei der Prüfkanal zum elektrischen Kontaktieren des zweiten Anschlusspols des ersten Anschlussterminals mittels der Prüfspitze bei bestehender elektrischer Verbindung zwischen dem ersten Anschlusspol des ersten Anschlussterminals und dem ersten Anschlusspol des dritten Anschlussterminals und bei getrennter elektrischer Verbindung zwischen dem zweiten Anschlusspol des ersten Anschlussterminals und dem zweiten Anschlusspol des dritten Anschlussterminals vorgesehen ist.

Dadurch wird in vorteilhafter Weise erreicht, dass ein Stromkreis über die ersten und zweiten Anschlusspole trotz der Trennung der elektrischen Verbindung zwischen den zweiten Anschlusspolen weiterhin über die Prüfspitze geführt werden kann, so dass eine besonders effiziente Strommessung möglich ist.

Die Anschlusspole des ersten Anschlussterminals können beispielsweise als Anschlusspins ausgeführt sein. In diesem Falle sind die Anschlusspole des zweiten Anschlussterminals als Anschlusstulpen ausgeführt. Die Anschlusspole des ersten Anschlussterminals können jedoch als Anschlusstulpen ausgebildet sein. In diesem Falle sind die Anschlusspole des zweiten Anschlussterminals bevorzugt als Anschlusspins ausgebildet. Dadurch wird in vorteilhafter Weise beispielsweise eine lösbare Steckverbindung zwischen dem ersten und dem zweiten Anschlussterminal ermöglicht. Die Anschlusspole des ersten und des zweiten Anschlussterminals können jedoch auch Klemmanschlusspole sein.

Zum elektrischen Kontaktieren des zweiten Anschlusspols des ersten Anschlussterminals kann die Prüfspitze beispielsweise unmittelbar oder mittelbar, beispielsweise über das zweite Anschlussterminal, das zweite Anschlusspol des ersten Anschlussterminals kontaktieren.

Gemäß einer Ausführungsform ist ein elastischer Klemmkontakt zum elektrischen Verbinden des zweiten Anschlusspols des zweiten Anschlussterminals mit dem zweiten Anschlusspol des dritten Anschlussterminals vorgesehen, wobei der elastische Klemmkontakt mittels der in den Prüfkanal einführbaren Prüfspitze elastisch auslenkbar ist, um die elektrische Verbindung zwischen dem zweiten Anschlusspol des zweiten Anschlussterminals und dem zweiten Anschlusspol des dritten Anschlussterminals für die Trennung der elektrischen Verbindung zwischen dem zweiten Anschlusspol des ersten Anschlussterminals und dem zweiten Anschlusspol des dritten Anschlussterminals zu trennen. Sind die zweiten Anschlusspole des ersten und des zweiten Anschlussterminals beispielsweise über eine Steckverbindung elektrisch verbunden, so wird die elektrische Verbindung zwischen den zweiten Anschlusspolen des ersten und des dritten Anschlussterminals automatisch durch eine Verwendung des elastischen Klemmkontakts von dem zweiten Anschlusspol des zweiten oder des dritten Anschlussterminals erreicht.

Gemäß einer Ausführungsform ist ein Halteabschnitt des elastisches Klemmkontaktes mit dem zweiten Anschlusspol des zweiten Anschlussterminals elektrisch verbunden, wobei ein Kontaktabschnitt des elastisches Klemmkontaktes in einer Ruhestellung gegen das zweite Anschlusspol des dritten Anschlussterminals presst, oder wobei ein Halteabschnitt des elastisches Klemmkontaktes mit dem zweiten Anschlusspol des dritten Anschlussterminals elektrisch verbunden ist und wobei ein Kontaktabschnitt des elastisches Klemmkontaktes in einer Ruhestellung gegen das zweite Anschlusspol des zweiten Anschlussterminals presst; wobei der zweite Anschlusspol des ersten Anschlussterminals und der erste Anschlusspol des zweiten Anschlussterminals über eine elektrische Steckverbindung verbunden sind; und wobei der Kontaktabschnitt des elastischen Klemmkontaktes aus der Ruhestellung zum Trennen der elektrischen Verbindung in eine Auslenkstellung auslenkbar ist. Der Halteabschnitt des elastischen Klemmkontaktes kann mit dem jeweiligen zweiten Anschlusspol beispielsweise mittels einer leitfähigen Klebung oder einer Lötverbindung dauerhaft verbunden sein. In der Auslenkstellung des Kontaktabschnittes wird der elektrische Kontakt zwischen den Kontaktabschnitt und dem zweiten Anschlusspol getrennt, wodurch ein Strompfad unterbrochen werden kann. Bei Ausbleiben der Auslenkung verbleibt der elastische Klemmkontakt in der Ruhestellung oder kehrt in diese und sorgt für einen elektrischen Kontakt zwischen den zweiten Anschlusspolen.

Gemäß einer Ausführungsform ist der elastische Klemmkontakt ein biegeelastischer Bügel.

Gemäß einer Ausführungsform sind das erste Anschlussterminal und das zweite Anschlussterminal über eine Steckverbindung elektrisch verbindbar.

Gemäß einer Ausführungsform sind der erste Anschlusspol und der zweite Anschlusspol des ersten Anschlussterminals als Anschlusspins geformt, wobei der erste Anschlusspol und der zweite Anschlusspol des zweiten Anschlussterminals als Anschlusstulpen geformt sind, in welche die Anschlusspins zum Herstellen der elektrischen Verbindung hineinsteckbar sind, oder wobei der erste Anschlusspol und der zweite Anschlusspol des ersten Anschlussterminals als Anschlusstulpen geformt sind und wobei der erste Anschlusspol und der zweite Anschlusspol des zweiten Anschlussterminals als Anschlusspins geformt sind, welche zum Herstellen der elektrischen Verbindung in die Anschlusstulpen hineinsteckbar sind.

Gemäß einer Ausführungsform ist der zweite Anschlusspol des ersten Anschlussterminals kürzer als der erste Anschlusspol des ersten Anschlussterminals, so dass bei bestehender elektrischer Verbindung zwischen dem ersten Anschlusspol des ersten Anschlussterminals und dem ersten Anschlusspol des zweiten Anschlussterminals die elektrische Verbindung zwischen dem zweiten Anschlusspol des ersten Anschlussterminals und dem zweiten Anschlusspol des zweiten Anschlussterminals trennbar ist, oder wobei der zweite Anschlusspol des zweiten Anschlussterminals kürzer als der erste Anschlusspol des zweiten Anschlussterminals ist, so dass bei bestehender elektrischer Verbindung zwischen dem ersten Anschlusspol des ersten Anschlussterminals und dem ersten Anschlusspol des zweiten Anschlussterminals die elektrische Verbindung zwischen dem zweiten Anschlusspol des ersten Anschlussterminals und dem zweiten Anschlusspol des zweiten Anschlussterminals trennbar ist. Dadurch wird in vorteilhafter Weise erreicht, dass bei einem Herausschieben des Modulelementes aus dem Modulgehäuse nur die elektrische Verbindung zwischen den zweiten Anschlusspolen unterbrochen wird, während die elektrische Verbindung zwischen den ersten Anschlusspolen bestehen bleibt. Auf diese Weise wird der Strompfad an einer definierten Stelle unterbrochen und kann beispielsweise zur Strommessung über eine Prüfspitze weitergeführt werden.

Gemäß einer Ausführungsform ist zum Trennen der elektrischen Verbindung zwischen den zweiten Anschlusspolen das Modulelement aus dem Modulgehäuse über eine vorbestimmte Schiebestrecke herausschiebbar.

Gemäß einer Ausführungsform ist die vorbestimmte Schiebestrecke durch ein Rastelement begrenzt. Das Rastelement kann beispielsweise eine Rastnase oder eine Rastausnehmung sein, welche am Modulelement oder an einer Wandung des Modulgehäuses, insbesondere an einer Wandung einer Modulaufnahme des Modulgehäuses angeordnet sein kann. Dadurch wird in vorteilhafter Weise eine Schiebestrecke für die Messzwecke definiert.

Gemäß einer Ausführungsform ist der Prüfkanal in dem Modulelement geformt und erstreckt sich bis zum Klemmkontakt. Der Prüfkanal kann beispielsweise durch eine Ausnehmung in dem Modulelement gebildet sein.

Gemäß einer Ausführungsform ist der Prüfkanal in dem Modulgehäuse geformt und erstreckt sich bis zum zweiten Anschlusspol des ersten Anschlussterminals. Der Prüfkanal kann durch eine Ausnehmung in dem Modulgehäuse gebildet sein.

Gemäß einer Ausführungsform ist das dritte elektrische Anschlussterminal für die lösbare Aufnahme, insbesondere für die kraftschlüssige Aufnahme, von elektrischen Leitungen vorgesehen. Hierzu kann das dritte elektrische Anschlussterminal Anschlusspole aufweisen, welche beispielsweise Klemmanschlusspole oder Schraubanschlusspole sind.

Die Anschlusspole des dritten Anschlussterminals sind bevorzugt untereinander in einer Reihe angeordnet und für die lösbare Aufnahme von elektrischen Leitungsenden vorgesehen.

Gemäß einer Ausführungsform weist das Modulgehäuse eine durch Seitenwände begrenzte Modulaufnahme für die Aufnahme des Modulelementes auf, und das Modulelement ist in der Modulaufnahme angeordnet oder in die Modulaufnahme einsetzbar. Die Modulaufnahme kann vorgesehen sein, eine Mehrzahl von Modulelementen untereinander oder übereinander aufzunehmen. Die Modulaufnahme weist dabei bevorzugt eine Breite auf, welche der Breite eines Modulelementes entspricht. In der Modulaufnahme sind beispielsweise Aufnahmenischen gebildet, in welchen Anschlusspole des ersten Anschlussterminals angeordnet sind.

Gemäß einer Ausführungsform sind die Anschlusspole des dritten Anschlussterminals untereinander angeordnet.

Gemäß einem weiteren Aspekt betrifft die Erfindung ein Verfahren zum Erfassen einer Stromstärke eines durch das elektrische Verbindungsmodul fließenden elektrischen Stroms, mit: Aufsetzen einer ersten Prüfspitze eines Strommessgerätes auf den ersten Anschlusspol des dritten Anschlussterminals; Trennen einer elektrischen Verbindung zwischen dem zweiten Anschlusspol des ersten Anschlussterminals und dem zweiten Anschlusspol des dritten Anschlussterminals bei bestehender elektrischer Verbindung zwischen dem ersten Anschlusspol des ersten Anschlussterminals und dem ersten Anschlusspol des dritten Anschlussterminals; elektrischem Kontaktieren des zweiten Anschlusspols des ersten Anschlussterminals mittels einer durch den Prüfkanal geführten zweiten Prüfspitze; und Erfassen der Stromstärke des zwischen der ersten Prüfspitze und der zweiten Prüfspitze fließenden elektrischen Stroms.

Weitere Merkmale des Verfahrens ergeben sich unmittelbar aus den Merkmalen des elektrischen Verbindungsmoduls.

Weitere Ausführungsbeispiele werden Bezug nehmend auf die beiliegenden Zeichnungen erläutert. Es zeigen:
- Fig. 1: einen Ausschnitt eines elektrischen Verbindungsmoduls gemäß einer Ausführungsform;
- Fig. 2: einen Ausschnitt eines elektrischen Verbindungsmoduls gemäß einer Ausführungsform;
- Fig. 3: einen Ausschnitt eines elektrischen Verbindungsmoduls gemäß einer Ausführungsform;
- Fig. 4: einen Ausschnitt eines elektrischen Verbindungsmoduls gemäß einer Ausführungsform;
- Fig. 5: einen Ausschnitt eines elektrischen Verbindungsmoduls gemäß einer Ausführungsform;
- Fig. 6: einen Ausschnitt eines elektrischen Verbindungsmoduls gemäß einer Ausführungsform; und
- Fig. 7: ein Diagramm eines Verfahrens zum Erfassen einer Stromstärke gemäß einer Ausführungsform.

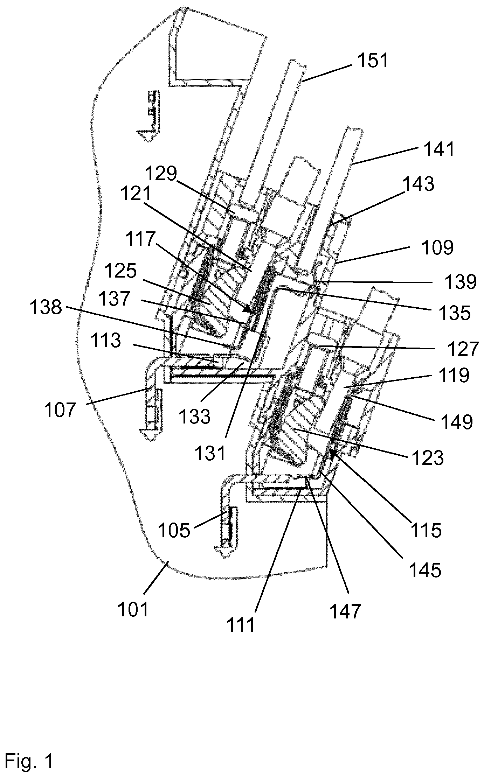

Fig. 1 zeigt ein elektrisches Verbindungsmodul mit einem Modulgehäuse 101, das ein erstes Anschlussterminal 105, 107 mit einem ersten Anschlusspol 105 und mit einem zweiten Anschlusspol 107 aufweist. Die Anschlusspole 105, 107 sind beispielsweise als Anschlusspins ausgeführt. Sie können jedoch auch als Anschlusstulpen ausgeführt sein.

Das elektrische Verbindungsmodul umfasst ferner ein Modulelement 109, das ein zweites Anschlussterminal 111, 113 mit einem ersten Anschlusspol 111 und einem zweiten Anschlusspol 113 umfasst. Die Anschlusspole 111, 113 des zweiten Anschlussterminals 111, 113 können beispielsweise als Anschlusstulpen ausgeführt sein. Sie können jedoch auch als Anschlusspins ausgeführt sein. Die Anschlusspole 105, 107 des ersten Anschlussterminals 105, 107 sowie die Anschlusspole 111, 113 bilden beispielsweise eine elektrische Steckverbindung. Das Modulelement 109 kann somit als ein mehrpoliger, insbesondere als ein zweipoliger Stecker, ausgeführt sein.

Das Modulelement 109 umfasst ferner ein drittes Anschlussterminal 115, 117 mit einem ersten Anschlusspol 115 und einem zweiten Anschlusspol 117. Das dritte Anschlussterminal 115, 117 ist beispielsweise vorgesehen, elektrische Leitungen 119, 121 kraftschlüssig und lösbar aufzunehmen. Hierzu können die Anschlusspole 115, 117 als Schraubanschlusspole mit jeweils einer auf ein jeweiliges Klemmkörper 123, 125 einwirkenden Schraube 127, 129 ausgeführt sein.

Zum Herstellen einer elektrischen Verbindung zwischen dem ersten Anschlussterminal 105, 107 sowie dem dritten Anschlussterminal 115, 117 ist das erste Anschlussterminal 105, 107 mit dem zweiten Anschlussterminal 111, 113 beispielweise mittels einer Steckverbindung elektrisch verbunden. Bei bestehender elektrischer Verbindung zwischen dem ersten Anschlusspol 111 des zweiten Anschlussterminals 111, 113 und dem ersten Anschlusspol 115 des dritten Anschlussterminals 115, 117 kann die elektrische Verbindung zwischen dem zweiten Anschlusspol 113 des zweiten Anschlussterminals 111, 113 und dem zweiten Anschlusspol 117 des dritten Anschlussterminals 115, 117 unterbrochen werden.

Zur Unterbrechung der elektrischen Verbindung zwischen den zweiten Anschlusspolen 113, 117 ist beispielsweise ein elastischer Klemmkontakt 131, beispielsweise ein elastischer Biegebügel, vorgesehen. Der Federkontakt ist mit einem Halteabschnitt 133, beispielsweise mit dem zweiten Anschluss 113 des zweiten Anschlussterminals 111, 113 dauerhaft, beispielsweise durch Löten, elektrisch verbunden. Der Klemmkontakt 131 umfasst ferner einen Kontaktabschnitt 135, welcher gegen einen Kontaktabschnitt 137 des zweiten Anschlusspols 117 des dritten Anschlussterminals 115, 117 anpressbar ist. An den Kontaktabschnitt 137 ist beispielsweise die elektrische Leitung 119 anklemmbar. Der Kontaktabschnitt 137 kann beispielsweise gebogen sein und einen abgewinkelten Halteabschnitt 138 aufweisen, welcher beispielsweise in einem Kunststoffabschnitt des Modulelementes 109 verankert sein kann.

Zum Auftrennen der Verbindung zwischen den zweiten Anschlusspolen 113, 117 umfasst der Klemmkontakt 131 einen gebogenen Aufnahmeabschnitt 139 für die Aufnahme einer Prüfspitze 141, welche von außen durch einen Prüfkanal 143, welcher sich bis zum Klemmkontakt 131 erstreckt, zum Verdrängen des Klemmkontaktes 131 einführbar ist.

Der erste Anschlusspol 111 des zweiten Anschlussterminals 111, 113 ist unabhängig von einer bestehenden oder nicht bestehenden elektrischen Verbindung zwischen den zweiten Anschlusspolen 113, 117 elektrisch mit dem ersten Anschluss 115 des ersten Anschlussterminals 105, 107 elektrisch verbindbar bzw. verbunden. Hierzu ist ein Verbindungskontakt 145, beispielsweise eine Verbindungsbrücke, vorgesehen, welcher mit dem ersten Anschlusspol 111 des zweiten Anschlussterminals 111, 113 über einen Halteabschnitt 147, welcher gebogen sein kann, dauerhaft, beispielsweise mittels Löten, verbunden ist. Der Kontaktanschluss 145 umfasst ferner einen Kontaktabschnitt 149, welcher an ein Leitungsende 121 anpressbar ist und welcher beispielsweise nicht aufgebogen werden kann. Die elektrische Verbindung zwischen den ersten Anschlusspolen 105, 111 und 115 kann beispielsweise einer konventionellen elektrischen Schraubpolverbindung entsprechen.

Ist mit den elektrischen Leitungen 119, 121 ein elektrischer Verbraucher verbunden, so fließt durch das elektrische Verbindungselement ein elektrischer Strom über die jeweils ersten Anschlusspole 105, 111, 115 und über die jeweils zweiten Anschlusspole 107, 113 und 117, welche einen Strompfad festlegen. Zum Unterbrechen des Strompfades wird die Prüfspitze 141 in den Prüfkanal 143 eingeführt, wodurch der elastische Klemmkontakt 131 aufgebogen wird, sodass die elektrische Verbindung zwischen den zweiten Anschlusspolen 113, 117 unterbrochen wird. Der Klemmkontakt 131 ist jedoch über den Aufnahmeabschnitt 139 mit der Prüfspitze 141 verbunden. Wird die weitere Prüfspitze 151 beispielsweise mit der leitfähigen Schraube 129 elektrisch verbunden, so wird der Strompfad über die Prüfspitzen 141, 151 wieder vervollständigt, so dass der in Fig. 1 dargestellte Strom I beispielsweise in die durch die in Fig. 1 eingezeichneten Pfeilrichtungen fließt.

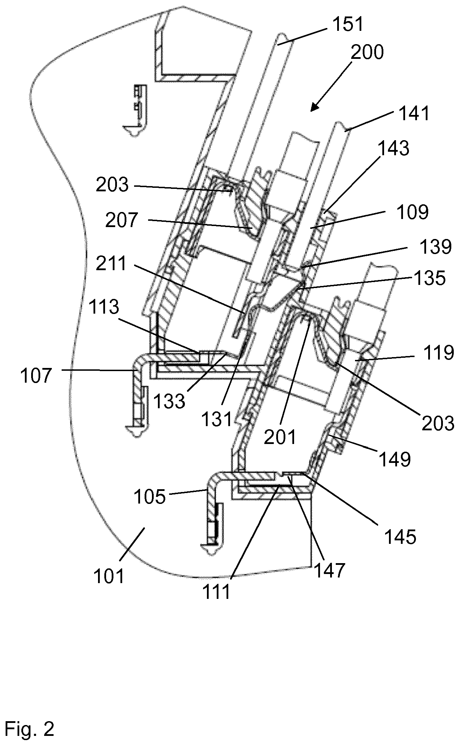

Fig. 2 zeigt einen Ausschnitt eines elektrischen Verbindungselementes mit einem Modulelement 200, bei dem im Unterschied zu dem in Fig. 2 dargestellten elektrischen Verbindungselement ein drittes Anschlussterminal 201, 203 mit einem ersten Anschlusspol 201 und einem zweiten Anschlusspol 203, welche für die Klemmaufnahme von elektrischen Leitungen 119, 121 vorgesehen sind. Hier umfassen der erste Anschlusspol 201 und der zweite Anschlusspol 203 jeweils eine Anschlussklemme 205 und 207.

Zum Herstellen einer elektrischen Verbindung zwischen den zweiten Anschlusspolen 113, 203 ist der Klemmkontakt 131, wie es im Zusammenhang mit Fig. 1 bereits erläutert wurde, verdrängbar bzw. gegen einen Kontaktabschnitt 209 anpressbar. Der Kontaktabschnitt 209 ist mit der elektrischen Leitung 119 mittels der Anschlussklemme 207 elektrisch kontaktierbar und umfasst einen Halteabschnitt 211, welcher beispielsweise in einem Gehäusematerial, beispielsweise Kunststoff, des Modulelementes 200 eingebettet ist.

Die Betriebsweise des in Fig. 2 dargestellten Verbindungselementes entspricht der Betriebsweise des in Fig. 1 dargestellten elektrischen Verbindungselementes mit dem Unterschied, dass statt der Schraubpolanschlüsse Klemmanschlüsse verwendet werden.

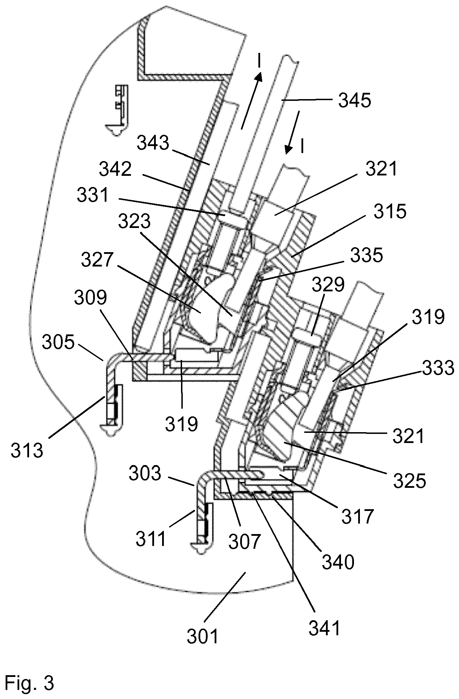

Fig. 3 zeigt ein elektrisches Verbindungselement mit einem Modulgehäuse 301, wobei ein erstes Anschlussterminal 303, 305 mit einem ersten Anschlusspol 303 und einem zweiten Anschlusspol 305 vorgesehen ist. Die Anschlusspole 303, 305 sind beispielsweise Pinanschlüsse oder Tulpenanschlüsse mit jeweils einem Kontaktabschnitt 307, 309 mit jeweils einem abgewinkelten Halteabschnitt 311, 313.

Das Modulgehäuse 301 ist für die Aufnahme von zumindest einem Modulelement 315 vorgesehen. Das Modulelement umfasst ein zweites Anschlussterminal mit einem ersten Anschlusspol 317 und mit einem zweiten Anschlusspol 319, welche jeweils als Tulpenanschlusspole oder als Pin-Anschlusspole ausgebildet sein können. Das elektrische Verbindungsmodul umfasst ferner ein drittes Anschlussterminal 321, 323, das beispielsweise konventionelle Schraubpolanschlüsse mit jeweils einem Klemmkörper 325, 327, einer Klemmschraube 329, 331 sowie ein Kontaktabschnitt 333, 335 umfassen kann. Die Kontaktabschnitte 333, 335 können mittels der Klemmkörper 325, 327 an die elektrischen Leitungen 119, 121 angeklemmt werden, wodurch eine elektrische Verbindung zwischen den elektrischen Leitungen 119, 121 und dem dritten Anschlussterminal 321, 323 hergestellt werden kann.

Die elektrische Verbindung zwischen den zweiten Anschlusspolen 305, 319 des ersten Anschlussterminals 303, 305 und des zweiten Anschlussterminals 317, 319 kann auch bei bestehender elektrischer Verbindung zwischen den ersten Anschlusspolen 303, 317 unterbrochen werden. Hierzu ist beispielsweise der wirksame Kontaktabschnitt 309 des zweiten Anschlusspols 305 kürzer ausgeführt als der Kontaktabschnitt 307 des ersten Anschlusspols 303. Wird das Modulelement 315 beispielsweise entlang einer vorbestimmten Schiebestrecke aus dem Modulgehäuse 301 herausgeschoben, so kann aufgrund des Längenunterschieds zwischen den Kontaktabschnitten 307, 309 die elektrische Verbindung zwischen den zweiten Anschlusspolen 305, 319 unterbrochen werden, weil beispielsweise der Kontaktabschnitt 309 aus dem Anschlusspol 319, welcher eine Anschlusstulpe sein kann, herausgeführt wird. Die elektrische Verbindung zwischen den ersten Anschlusspolen 303, 317 besteht jedoch bei definierter Schiebestrecke nach wie vor, weil der längere Kontaktabschnitt 307 des ersten Anschlusspols 303 trotz der Verschiebung des Modulelementes 315 beispielsweise in der Anschlusstulpe 317 verbleibt. Auf diese Weise kann der Strompfad unterbrochen werden. Zum Begrenzen der Schiebestrecke können an einer Bodenwandung einer Modulaufnahme des Modulgehäuses, welche das Modulelement aufnimmt, beispielsweise eine oder mehrere Ausnehmungen 340, vorgesehen sein. Das Modulelement 315 kann hierzu korrespondierende Erhebungen 341, beispielsweise Rastnasen, aufweisen, welche die Ausnehmungen 340 eindringen.

Zum Kontaktieren des zweiten Anschlusspols 305 des ersten Anschlussterminals 303, 305 ist ein Prüfkanal 342 vorgesehen, in welchen eine Prüfspitze 343 einführbar ist. Eine weitere Prüfspitze 345 kann zum Vervollständigen des Strompfads beispielsweise mit der Schraube 331 kontaktiert werden, so dass ein elektrischer Strom beispielsweise über die Prüfspitzen 343, 345 fließt.

Gemäß einer Ausführungsform können die in Fig. 3 dargestellten Schraubanschlusspole durch Klemmanschlusspole ersetzt werden.

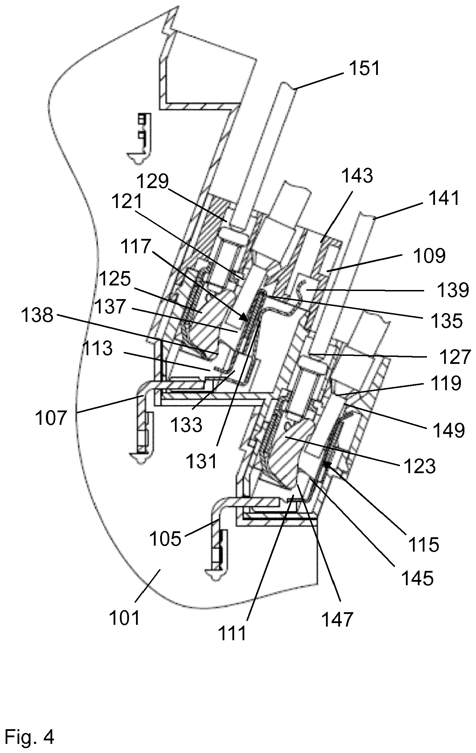

Fig. 4 zeigt das in Fig. 1 dargestellte elektrische Verbindungsmodul für den Fall einer Spannungsmessung, bei der die Prüfspitzen 141, 151 direkt die Schrauben 127, 129 kontaktieren. Der Klemmkontakt 131 ist dabei in seiner Ruhestellung und presst gegen die Kontaktabschnitt 137 des zweiten Anschlusspols 117 des zweiten Anschlussterminals 115, 117.

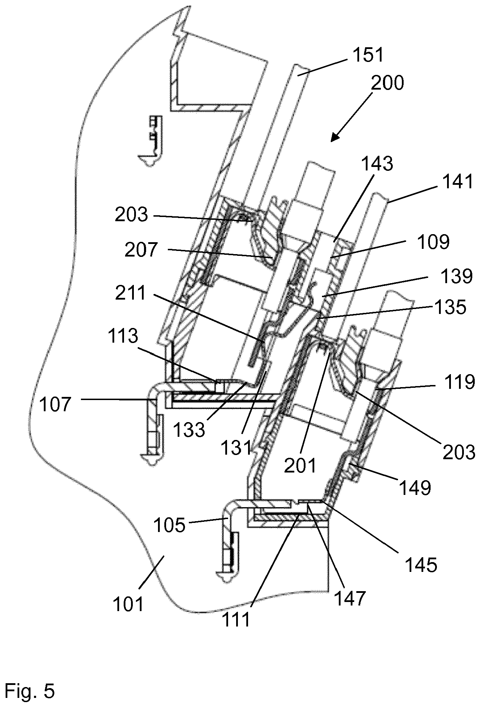

Fig. 5 zeigt das in Fig. 2 dargestellte elektrische Verbindungsmodul für den Fall einer Spannungsmessung, bei der die Prüfspitzen 141, 151 direkt die Klemmen 201, 203 kontaktieren.

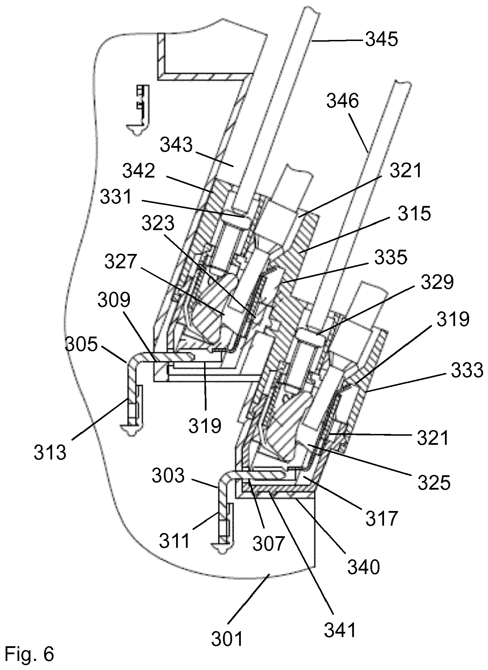

Fig. 6 zeigt das in Fig. 3 dargestellte elektrische Verbindungsmodul für den Fall einer Spannungsmessung, bei der die Prüfspitzen 345, 346 direkt die Schrauben 127, 129 kontaktieren. Der Klemmkontakt 131 ist dabei in seiner Ruhestellung und presst gegen die Kontaktabschnitt 137 des zweiten Anschlusspols 117 des zweiten Anschlussterminals 115, 117.

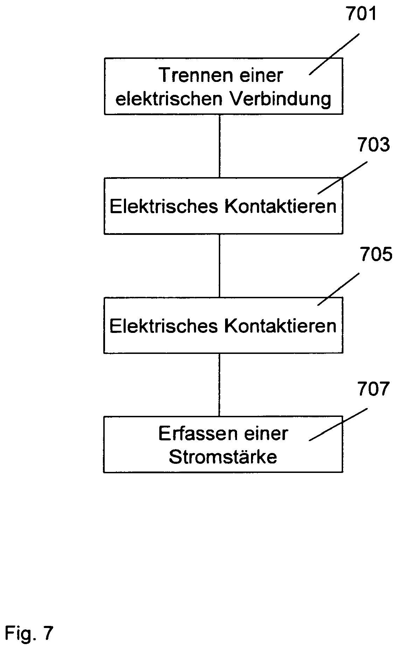

Fig. 7 zeigt ein Diagramm eines Verfahrens zum Erfassen einer Stromstärke eines durch ein elektrisches Verbindungsmodul, beispielsweise durch eines der in den Fig. 1 bis 4 dargestellten elektrischen Verbindungsmodule, fliessenden elektrischen Stroms. Das Verfahren umfasst: Trennen 701 einer elektrischen Verbindung zwischen dem zweiten Anschlusspol des ersten Anschlussterminals und dem zweiten Anschlusspol des dritten Anschlussterminals, elektrisches Kontaktieren 703 des zweiten Anschlusspols des ersten Anschlussterminals mittels einer durch den Prüfkanal geführten ersten Prüfspitze, elektrisches Kontaktieren 703 des zweiten Anschlusspols des dritten Anschlussterminals mittels einer zweiten Prüfspitze bei bestehender elektrischer Verbindung zwischen dem ersten Anschlusspol des ersten Anschlussterminals und dem ersten Anschlusspol des dritten Anschlussterminals, und Erfassen 707 der Stromstärke des zwischen der ersten Prüfspitze und der zweiten Prüfspitze fließenden elektrischen Stroms mittels des Strommessgerätes.

Die Schritte des Trennens 701 und des elektrischen Kontaktierens 703 können gleichzeitig oder nacheinander ausgeführt werden. Die Schritte des Kontaktierens 7703, 705 können ebenfalls gleichzeitig oder nacheinander ausgeführt werden.

Zum elektrischen Kontaktieren des zweiten Anschlusspols des ersten Anschlussterminals kann die Prüfspitze beispielsweise unmittelbar oder mittelbar, beispielsweise über das zweite Anschlussterminal, das zweite Anschlusspol des ersten Anschlussterminals kontaktieren.

Weitere Schritte des in Fig. 7 dargestellten Verfahrens ergeben sich unmittelbar aus der Funktionalität der in den Fig. 1 bis 6 dargestellten elektrischen Elemente.

Die Funktionsweise der in den Fig. 1 bis 6 dargestellten elektrischen Verbindungselemente wurde am Beispiel der Auftrennung der elektrischen Verbindung zwischen den zweiten Anschlusspolen erläutert. Die vorstehenden Ausführungen gelten jedoch sinngemäß auch dann, wenn die elektrischen Verbindungen statt bei den zweiten Anschlusspolen bei den ersten Anschlusspolen unterbrochen werden. Die vorstehenden Ausführungen gelten jedoch auch dann sinngemäß, wenn die elektrischen Verbindungen sowohl bei den ersten Anschlusspolen als auch bei den zweiten Anschlusspolen unterbrochen werden.

### Bezugszeichenliste

- 101: Modulgehäuse
- 105, 107: Anschlussterminal
- 109: Modulelement
- 111, 113: Anschlussterminal
- 115, 117: Anschlussterminal
- 119: elektrische Leitung
- 121: elektrische Leitung
- 123: Klemmkörper
- 125: Klemmkörper
- 127: Schraube
- 129: Schraube
- 131: Klemmkontakt
- 133: Halteabschnitt
- 135: Kontaktabschnitt
- 137: Kontaktabschnitt
- 138: Halteabschnitt
- 139: Aufnahmeabschnitt
- 141: Prüfspitze
- 143: Prüfkanal
- 145: Verbindungskontakt
- 147: Halteabschnitt
- 149: Kontaktabschnitt
- 151: weitere Prüfspitze
- 200: Modulelement
- 201, 203: Anschlussterminal
- 205: Anschlussklemme
- 207: Anschlussklemme
- 209: Kontaktabschnitt
- 211: Halteabschnitt
- 301: Modulgehäuse
- 303, 305: Anschlussterminal
- 307: Kontaktabschnitt
- 309: Kontaktabschnitt
- 311: Halteabschnitt
- 313: Halteabschnitt
- 315: Modulelement
- 317, 319: Anschlussterminal
- 321, 323: Anschlussterminal
- 325: Klemmkörper
- 327: Klemmkörper
- 329: Klemmschraube
- 331: Klemmschraube
- 333: Kontaktabschnitt
- 335: Kontaktabschnitt
- 340: Ausnehmung
- 341: Erhebung
- 342: Prüfkanal
- 343: Prüfspitze
- 345: Prüfspitze
- 346: Prüfspitze
- 401: Modulelement
- 403, 405: Anschlussterminal
- 405: Anschlussterminal
- 407: Klemmkörper
- 409: Klemmkörper
- 411: Schraube
- 413: Schraube
- 701: Aufsetzen einer Prüfspitze
- 705: elektrisches Kontaktieren
- 707: Erfassen der Stromstärke

## Patentansprüche

1. Elektrisches Verbindungsmodul, mit:
einem Modulgehäuse (101), das ein erstes elektrisches Anschlussterminal (105, 107) mit einem ersten Anschlusspol (105) und einem zweiten Anschlusspol (107) umfasst, das eine Modulaufnahme für die Aufnahme eines Modulelementes (109) aufweist;
einem Modulelement (109) mit einem zweiten elektrischen Anschlussterminal (111, 113), das ein erstes Anschlusspol (111) und ein zweites Anschlusspol (113) umfasst, und mit einem dritten elektrischen Anschlussterminal (115, 117), das ein erstes Anschlusspol (115) und ein zweites Anschlusspol (117) umfasst; das in die Modulaufnahme einsetzbar ist; und
einem Prüfkanal (143) für die Aufnahme einer Prüfspitze;
**dadurch gekennzeichnet, dass**
der erste Anschlusspol (105) des ersten elektrischen Anschlussterminals (105, 107) mit dem ersten Anschlusspol (111) des zweiten elektrischen Anschlussterminals (111, 113) elektrisch verbindbar ist, wobei der erste Anschlusspol (111) des zweiten elektrischen Anschlussterminals (111, 113) mit dem ersten Anschlusspol (115) des dritten elektrischen Anschlussterminals (115, 117) elektrisch verbindbar ist, wobei
der zweite Anschlusspol (107) des ersten elektrischen Anschlussterminals (105, 107) mit dem zweiten Anschlusspol (113) des zweiten elektrischen Anschlussterminals (111, 113) elektrisch verbindbar ist, wobei der zweite Anschlusspol (113) des zweiten elektrischen Anschlussterminals (111, 113) mit dem zweiten Anschlusspol (117) des dritten elektrischen Anschlussterminals (115, 117) elektrisch verbindbar ist, so dass das erste elektrische Anschlussterminal (105, 107) mit dem dritten elektrischen Anschlussterminal (115, 117) elektrisch über das zweite elektrische Anschlussterminal (111, 113) verbindbar ist, wobei
bei bestehender elektrischer Verbindung zwischen dem ersten Anschlusspol (105) des ersten Anschlussterminals (105, 107) und dem ersten Anschlusspol (115) des dritten Anschlussterminals (115, 117) die elektrische Verbindung zwischen dem zweiten Anschlusspol (107) des ersten Anschlussterminals (105, 107) und dem zweiten Anschlusspol (117) des dritten Anschlussterminals (115, 117) trennbar ist, wobei
der Prüfkanal (143) zum elektrischen Kontaktieren des zweiten Anschlusspols (107) des ersten Anschlussterminals (105, 107) mittels der Prüfspitze vorgesehen ist, falls eine elektrische Verbindung zwischen dem ersten Anschlusspol (105) des ersten Anschlussterminals (105, 107) und dem ersten Anschlusspol (115) des dritten Anschlussterminals (115, 117) besteht, und wobei
der Prüfkanal (143) zum elektrischen Kontaktieren des zweiten Anschlusspols (107) des ersten Anschlussterminals (105, 107) mittels der Prüfspitze vorgesehen ist, falls eine elektrische Verbindung zwischen dem zweiten Anschlusspol (107) des ersten Anschlussterminals (105, 107) und dem zweiten Anschlusspol (117) des dritten Anschlussterminals (115, 117) getrennt ist.

2. Elektrisches Verbindungsmodul nach Anspruch 1, wobei ein Klemmkontakt (131) zum elektrischen Verbinden des zweiten Anschlusspols (113) des zweiten Anschlussterminals (111, 113) mit dem zweiten Anschlusspol (117) des dritten Anschlussterminals (115, 117) vorgesehen ist, wobei der Klemmkontakt (131) mittels der in den Prüfkanal (143) einführbaren Prüfspitze auslenkbar ist, um die elektrische Verbindung zwischen dem zweiten Anschlusspol (113) des zweiten Anschlussterminals (111, 113) und dem zweiten Anschlusspol (117) des dritten Anschlussterminals (115, 117) für die Trennung der elektrischen Verbindung zwischen dem zweiten Anschlusspol (107) des ersten Anschlussterminals (105, 107) und dem zweiten Anschlusspol (117) des dritten Anschlussterminals (115, 117) zu trennen.

3. Elektrisches Verbindungsmodul nach Anspruch 2, wobei
ein Halteabschnitt (133) des Klemmkontaktes (131) mit dem zweiten Anschlusspol (113) des zweiten Anschlussterminals (111, 113) elektrisch verbunden ist und wobei ein Kontaktabschnitt (135) des Klemmkontaktes (131) in einer Ruhestellung gegen das zweite Anschlusspol (117) des dritten Anschlussterminals (115, 117) presst, oder wobei
ein Halteabschnitt (133) des Klemmkontaktes (131) mit dem zweiten Anschlusspol (117) des dritten Anschlussterminals (115, 117) elektrisch verbunden ist und wobei ein Kontaktabschnitt (137) des Klemmkontaktes (131) in einer Ruhestellung gegen das zweite Anschlusspol (113) des zweiten Anschlussterminals (111, 113) presst; wobei
der zweite Anschlusspol (107) des ersten Anschlussterminals (105, 107) und der zweite Anschlusspol (113) des zweiten Anschlussterminals (111, 113) über eine elektrische Steckverbindung verbunden sind; und wobei
der Kontaktabschnitt (135) des Klemmkontaktes (131) aus der Ruhestellung zum Trennen der elektrischen Verbindung in eine Auslenkstellung auslenkbar ist.

4. Elektrisches Verbindungsmodul nach Anspruch 2 oder 3, wobei der Klemmkontakt (131) ein biegeelastischer Bügel ist.

5. Elektrisches Verbindungsmodul nach einem der vorstehenden Ansprüche, wobei das erste Anschlussterminal (105, 107) und das zweite Anschlussterminal (111, 113) über eine Steckverbindung elektrisch verbindbar sind.

6. Elektrisches Verbindungsmodul nach Anspruch 5, wobei der erste Anschlusspol (105) und der zweite Anschlusspol (107) des ersten Anschlussterminals (105, 107) als Anschlusspins geformt sind und wobei der erste Anschlusspol (111) und der zweite Anschlusspol (113) des zweiten Anschlussterminals (111, 113) als Anschlusstulpen geformt sind, in welche die Anschlusspins zum Herstellen der elektrischen Verbindung hineinsteckbar sind, oder wobei
der erste Anschlusspol (105) und der zweite Anschlusspol (107) des ersten Anschlussterminals (105, 107) als Anschlusstulpen geformt sind und wobei der erste Anschlusspol (111) und der zweite Anschlusspol (113) des zweiten Anschlussterminals (111, 113) als Anschlusspins geformt sind, welche zum Herstellen der elektrischen Verbindung in die Anschlusstulpen hineinsteckbar sind.

7. Elektrisches Verbindungsmodul nach Anspruch 5 oder 6, wobei
der zweite Anschlusspol (107) des ersten Anschlussterminals (105, 107) kürzer als der erste Anschlusspol (105) des ersten Anschlussterminals (105, 107) ist, sodass bei bestehender elektrischer Verbindung zwischen dem ersten Anschlusspol (105) des ersten Anschlussterminals (105, 107) und dem ersten Anschlusspol (111) des zweiten Anschlussterminals (111, 113) die elektrische Verbindung zwischen dem zweiten Anschlusspol (107) des ersten Anschlussterminals (105, 107) und dem zweiten Anschlusspol (113) des zweiten Anschlussterminals (111, 113) trennbar ist, oder wobei
der zweite Anschlusspol (113) des zweiten Anschlussterminals (111, 113) kürzer als der erste Anschlusspol (111) des zweiten Anschlussterminals (111, 113) ist, sodass bei bestehender elektrischer Verbindung zwischen dem ersten Anschlusspol (105) des ersten Anschlussterminals (105, 107) und dem ersten Anschlusspol (111) des zweiten Anschlussterminals (111, 113) die elektrische Verbindung zwischen dem zweiten Anschlusspol (107) des ersten Anschlussterminals (105, 107) und dem zweiten Anschlusspol (113) des zweiten Anschlussterminals (111, 113) trennbar ist.

8. Elektrisches Verbindungsmodul nach Anspruch 5, 6 oder 7, wobei zum Trennen der elektrischen Verbindung zwischen den zweiten Anschlusspolen (107, 113) das Modulelement (109) aus dem Modulgehäuse (101) über eine vorbestimmte Schiebestrecke herausschiebbar ist.

9. Elektrisches Verbindungsmodul nach Anspruch 8, wobei die vorbestimmte Schiebestrecke durch ein Rastelement (340, 341) begrenzt ist.

10. Elektrisches Verbindungsmodul nach einem der vorstehenden Ansprüche 2 bis 4, wobei der Prüfkanal (143) in dem Modulelement (109) geformt ist und sich bis zum Klemmkontakt (131) erstreckt.

11. Elektrisches Verbindungsmodul nach einem der vorstehenden Ansprüche 5 bis 7, wobei der Prüfkanal (342) in dem Modulgehäuse (301) geformt ist und sich bis zum zweiten Anschlusspol (305) des ersten Anschlussterminals (303, 305) erstreckt.

12. Elektrisches Verbindungsmodul nach einem der vorstehenden Ansprüche, wobei das dritte elektrische Anschlussterminal (115, 117) für die lösbare Aufnahme, insbesondere für die kraftschlüssige Aufnahme, von elektrischen Leitungen vorgesehen ist.

13. Elektrisches Verbindungsmodul nach einem der vorstehenden Ansprüche, wobei die Anschlusspole (115, 117) des dritten Anschlussterminals (115, 117) untereinander angeordnet sind.

14. Verfahren zum Erfassen einer Stromstärke eines durch das elektrische Verbindungsmodul nach einem der Ansprüche 1 bis 13 fließenden elektrischen Stroms, **gekennzeichnet durch**:
Trennen (701) einer elektrischen Verbindung zwischen dem zweiten Anschlusspol des ersten Anschlussterminals und dem zweiten Anschlusspol des dritten Anschlussterminals,
elektrisches Kontaktieren (703) des zweiten Anschlusspols des ersten Anschlussterminals mittels einer durch den Prüfkanal geführten ersten Prüfspitze;
elektrisches Kontaktieren (703) des zweiten Anschlusspols des dritten Anschlussterminals mittels einer zweiten Prüfspitze bei bestehender elektrischer Verbindung zwischen dem ersten Anschlusspol des ersten Anschlussterminals und dem ersten Anschlusspol des dritten Anschlussterminals; und
Erfassen (707) der Stromstärke des zwischen der ersten Prüfspitze und der zweiten Prüfspitze fließenden elektrischen Stroms.

## Claims

1. Electrical connecting module comprising:
a module housing (101), which comprises a first electrical connection terminal (105, 107) having a first connection pole (105) and a second connection pole (107), which has a module receptacle for receiving a module element (109);
a module element (109) having a second electrical connection terminal (111, 113), which comprises a first connection pole (111) and a second connection pole (113), and having a third electrical connection terminal (115, 117), which comprises a first connection pole (115) and a second connection pole (117); which is insertable into the module receptacle; and
a test channel (143) for receiving a test tip;
**characterized in that**
the first connection pole (105) of the first electrical connection terminal (105, 107) is electrically connectable to the first connection pole (111) of the second electrical connection terminal (111, 113), wherein the first connection pole (111) of the second electrical connection terminal (111, 113) is electrically connectable to the first connection pole (115) of the third electrical connection terminal (115, 117), wherein
the second connection pole (107) of the first electrical connection terminal (105, 107) is electrically connectable to the second connection pole (113) of the second electrical connection terminal (111, 113), wherein the second connection pole (113) of the second electrical connection terminal (111, 113) is electrically connectable to the second connection pole (117) of the third electrical connection terminal (115, 117), such that first electrical connection terminal (105, 107) is electrically connectable to the third electrical connection terminal (115, 117) via the second electrical connection terminal (111, 113), wherein
with an existing electrical connection between the first connection pole (105) of the first connection terminal (105, 107) and the first connection pole (115) of the third connection terminal (115, 117), the electrical connection between the second connection pole (107) of the first connection terminal (105, 107) and the second connection pole (117) of the third connection terminal (115, 117) is disconnectable, wherein
the test channel (143) is provided for electrically contacting the second connection pole (107) of the first connection terminal (105, 107) by means of the test tip if there is an existing electrical connection between the first connection pole (105) of the first connection terminal (105, 107) and the first connection pole (115) of the third connection terminal (115, 117), and wherein
the test channel (143) is provided for electrically contacting the second connection pole (107) of the first connection terminal (105, 107) by means of the test tip if an electrical connection between the second connection pole (107) of the first connection terminal (105, 107) and the second connection pole (117) of the third connection terminal (115, 117) is disconnected.

2. Electrical connecting module according to Claim 1, wherein a clamping contact (131) is provided for electrically connecting the second connection pole (113) of the second connection terminal (111, 113) to the second connection pole (117) of the third connection terminal (115, 117), wherein the clamping contact (131) is deflectable by means of the test tip introducible into the test channel (143) in order to disconnect the electrical connection between the second connection pole (113) of the second connection terminal (111, 113) and the second connection pole (117) of the third connection terminal (115, 117) for the disconnection of the electrical connection between the second connection pole (107) of the first connection terminal (105, 107) and the second connection pole (117) of the third connection terminal (115, 117).

3. Electrical connecting module according to Claim 2, wherein
a holding section (133) of the clamping contact (131) is electrically connected to the second connection pole (113) of the second connection terminal (111, 113), and wherein a contact section (135) of the clamping contact (131) in a rest position presses against the second connection pole (117) of the third connection terminal (115, 117), or wherein
a holding section (133) of the clamping contact (131) is electrically connected to the second connection pole (117) of the third connection terminal (115, 117), and wherein a contact section (137) of the clamping contact (131) in a rest position presses against the second connection pole (113) of the second connection terminal (111, 113); wherein
the second connection pole (107) of the first connection terminal (105, 107) and the second connection pole (113) of the second connection terminal (111, 113) are connected via an electrical plug connection; and wherein
the contact section (135) of the clamping contact (131) is deflectable into a deflection position from the rest position for disconnecting the electrical connection.

4. Electrical connecting module according to Claim 2 or 3, wherein the clamping contact (131) is a flexurally elastic clip.

5. Electrical connecting module according to any of the preceding claims, wherein the first connection terminal (105, 107) and the second connection terminal (111, 113) are electrically connectable via a plug connection.

6. Electrical connecting module according to Claim 5, wherein the first connection pole (105) and the second connection pole (107) of the first connection terminal (105, 107) are shaped as connection pins, and wherein the first connection pole (111) and the second connection pole (113) of the second connection terminal (111, 113) are shaped as connection tulips, into which the connection pins are pluggable in order to produce the electrical connection, or wherein
the first connection pole (105) and the second connection pole (107) of the first connection terminal (105, 107) are shaped as connection tulips, and wherein the first connection pole (111) and the second connection pole (113) of the second connection terminal (111, 113) are shaped as connection pins, which are pluggable into the connection tulips in order to produce the electrical connection.

7. Electrical connecting module according to Claim 5 or 6, wherein
the second connection pole (107) of the first connection terminal (105, 107) is shorter than the first connection pole (105) of the first connection terminal (105, 107), such that with an existing electrical connection between the first connection pole (105) of the first connection terminal (105, 107) and the first connection pole (111) of the second connection terminal (111, 113) the electrical connection between the second connection pole (107) of the first connection terminal (105, 107) and the second connection pole (113) of the second connection terminal (111, 113) is disconnectable, or wherein
the second connection pole (113) of the second connection terminal (111, 113) is shorter than the first connection pole (111) of the second connection terminal (111, 113), such that with an existing electrical connection between the first connection pole (105) of the first connection terminal (105, 107) and the first connection pole (111) of the second connection terminal (111, 113), the electrical connection between the second connection pole (107) of the first connection terminal (105, 107) and the second connection pole (113) of the second connection terminal (111, 113) is disconnectable.

8. Electrical connecting module according to Claim 5, 6 or 7, wherein, for disconnecting the electrical connection between the second connection poles (107, 113), the module element (109) is able to be slid out of the module housing (101) via a predetermined sliding path.

9. Electrical connecting module according to Claim 8, wherein the predetermined sliding path is delimited by a latching element (340, 341).

10. Electrical connecting module according to any of the preceding Claims 2 to 4, wherein the test channel (143) is shaped in the module element (109) and extends as far as the clamping contact (131).

11. Electrical connecting module according to any of the preceding Claims 5 to 7, wherein the test channel (342) is shaped in the module housing (301) and extends as far as the second (305) of the first connection terminal (303, 305).

12. Electrical connecting module according to any of the preceding claims, wherein the third electrical connection terminal (115, 117) is provided for receiving electrical lines releasably, in particular for receiving electrical lines in a force-locking manner.

13. Electrical connecting module according to any of the preceding claims, wherein the connection poles (115, 117) of the third connection terminal (115, 117) are arranged one below the other.

14. Method for detecting a current intensity of an electric current flowing through the electrical connecting module according to any of Claims 1 to 13, **characterized by**:
disconnecting (701) an electrical connection between the second connection pole of the first connection terminal and the second connection pole of the third connection terminal,
electrically contacting (703) the second connection pole of the first connection terminal by means of a first test tip guided through the test channel;
electrically contacting (703) the second connection pole of the third connection terminal by means of a second test tip with an existing electrical connection between the first connection pole of the first connection terminal and the first connection pole of the third connection terminal; and
detecting (707) the current intensity of the electric current flowing between the first test tip and the second test tip.

## Revendications

1. Module de raccordement électrique, comportant :
un boîtier de module (101) comprenant une première borne de raccordement électrique (105, 107) comportant un premier pôle de raccordement (105) et un deuxième pôle de raccordement (107), qui comporte un logement pour module destiné à recevoir un élément modulaire (109) ;
un élément modulaire (109) comportant une deuxième borne de raccordement électrique (111, 113) comprenant un premier pôle de raccordement (111) et un deuxième pôle de raccordement (113), et comportant une troisième borne de raccordement électrique (115, 117) comprenant un premier pôle de raccordement (115) et un deuxième pôle de raccordement (117) ; qui peut être inséré dans le logement pour module ; et
un canal de test (143) destiné à recevoir une sonde de test ;
**caractérisé en ce que**
le premier pôle de raccordement (105) de la première borne de raccordement électrique (105, 107) peut être relié électriquement au premier pôle de raccordement (111) de la deuxième borne de raccordement électrique (111, 113), dans lequel le premier pôle de raccordement (111) de la deuxième borne de raccordement électrique (111, 113) peut être relié électriquement au premier pôle de raccordement (115) de la troisième borne de raccordement électrique (115, 117), dans lequel
le deuxième pôle de raccordement (107) de la première borne de raccordement électrique (105, 107) peut être relié électriquement au deuxième pôle de raccordement (113) de la deuxième borne de raccordement électrique (111, 113), dans lequel le deuxième pôle de raccordement (113) de la deuxième borne de raccordement électrique (111, 113) peut être relié électriquement au deuxième pôle de raccordement (117) de la troisième borne de raccordement électrique (115, 117), de manière à ce que la première borne de raccordement électrique (105, 107) puisse être reliée électriquement à la troisième borne de raccordement électrique (115, 117) par l'intermédiaire de la deuxième borne de raccordement électrique (111, 113), dans lequel
lorsqu'un raccordement électrique est établi entre le premier pôle de raccordement (105) de la première borne de raccordement (105, 107) et le premier pôle de raccordement (115) de la troisième borne de raccordement (115, 117), la liaison électrique entre le deuxième pôle de raccordement (107) de la première borne de raccordement (105, 107) et le deuxième pôle de raccordement (117) de la troisième borne de raccordement (115, 117) peut être interrompue, dans lequel
le canal de test (143) est prévu pour établir un contact électrique entre le deuxième pôle de raccordement (107) de la première borne de raccordement (105, 107) au moyen de la sonde de test lorsqu'une liaison électrique est établie entre le premier pôle de raccordement (105) de la première borne de raccordement (105, 107) et le premier pôle de raccordement (115) de la troisième borne de raccordement (115, 117), et dans lequel
le canal de test (143) est prévu pour établir un contact électrique entre le deuxième pôle de raccordement (107) de la première borne de raccordement (105, 107) au moyen de la sonde de test lorsqu'une liaison électrique entre le deuxième pôle de raccordement (107) de la première borne de raccordement (105, 107) et le deuxième pôle de raccordement (117) de la troisième borne de raccordement (115, 117) est interrompue.

2. Module de raccordement électrique selon la revendication 1, dans lequel il est prévu un contact de serrage (131) pour le raccordement électrique du deuxième pôle de raccordement (113) de la deuxième borne de raccordement (111, 113) au deuxième pôle de raccordement (117) de la troisième borne de raccordement (115, 117), dans lequel le contact de serrage (131) peut être écarté au moyen de la sonde de test pouvant être introduite dans le canal de test (143) afin d'interrompre la liaison électrique entre le deuxième pôle de raccordement (113) de la deuxième borne de raccordement (111, 113) et le deuxième pôle de raccordement (117) de la troisième borne de raccordement (115, 117) pour interrompre la liaison électrique entre le deuxième pôle de raccordement (107) de la première borne de raccordement (105, 107) et le deuxième pôle de raccordement (117) de la troisième borne de raccordement (115, 117).

3. Module de raccordement électrique selon la revendication 2, dans lequel
une section de maintien (133) du contact de serrage (131) est reliée électriquement au deuxième pôle de raccordement (113) de la deuxième borne de raccordement (111, 113) et dans lequel une section de contact (135) du contact de serrage (131), à une position de repos, exerce une pression contre le deuxième pôle de raccordement (117) de la troisième borne de raccordement (115, 117), ou dans lequel
une section de maintien (133) du contact de serrage (131) est reliée électriquement au deuxième pôle de raccordement (117) de la troisième borne de raccordement (115, 117) et dans lequel une section de contact (137) du contact de serrage (131), à une position de repos, exerce une pression contre le deuxième pôle de raccordement (113) de la deuxième borne de raccordement (111, 113) ; dans lequel
le deuxième pôle de raccordement (107) de la première borne de raccordement (105, 107) et le deuxième pôle de raccordement (113) de la deuxième borne de raccordement (111, 113) sont reliés par l'intermédiaire d'une liaison par fiche électrique ; et dans lequel
la section de contact (135) du contact de serrage (131) peut être écartée de la position de repos à une position écartée pour interrompre la liaison électrique.

4. Module de raccordement électrique selon la revendication 2 ou 3, dans lequel le contact de serrage (131) est un étrier déformable élastiquement.

5. Module de raccordement électrique selon l'une des revendications précédentes, dans lequel la première borne de raccordement (105, 107) et la deuxième borne de raccordement (111, 113) peuvent être reliées électriquement par l'intermédiaire d'une connexion par fiche.

6. Module de raccordement électrique selon la revendication 5, dans lequel le premier pôle de raccordement (105) et le deuxième pôle de raccordement (107) de la première borne de raccordement (105, 107) sont réalisés sous la forme de broches de raccordement et dans lequel le premier pôle de raccordement (111) et le deuxième pôle de raccordement (113) de la deuxième borne de raccordement (111, 113) sont réalisés sous la forme de tulipes de raccordement dans lesquelles les broches de raccordement peuvent être insérées pour établir la liaison électrique, ou dans lequel
le premier pôle de raccordement (105) et le deuxième pôle de raccordement (107) de la première borne de raccordement (105, 107) sont réalisés sous la forme de tulipes de raccordement et dans lequel le premier pôle de raccordement (111) et le deuxième pôle de raccordement (113) de la deuxième borne de raccordement (111, 113) sont réalisés sous la forme de broches de raccordement qui peuvent être insérées dans les tulipes de raccordement pour établir la liaison électrique.

7. Module de raccordement électrique selon la revendication 5 ou 6, dans lequel
le deuxième pôle de raccordement (107) de la première borne de raccordement (105, 107) est plus court que le premier pôle de raccordement (105) de la première borne de raccordement (105, 107) de manière à ce que, lorsqu'une liaison électrique est établie entre le premier pôle de raccordement (105) de la première borne de raccordement (105, 107) et le premier pôle de raccordement (111) de la deuxième borne de raccordement (111, 113), la liaison électrique entre le deuxième pôle de raccordement (107) de la première borne de raccordement (105, 107) et le deuxième pôle de raccordement (113) de la deuxième borne de raccordement (111, 113) puisse être interrompue, ou dans lequel
le deuxième pôle de raccordement (113) de la deuxième borne de raccordement (111, 113) est plus court que le premier pôle de raccordement (111) de la deuxième borne de raccordement (111, 113), de manière à ce que, lorsqu'une liaison électrique est établie entre le premier pôle de raccordement (105) de la première borne de raccordement (105, 107) et le premier pôle de raccordement (111) de la deuxième borne de raccordement (111, 113), la liaison électrique entre le deuxième pôle de raccordement (107) de la première borne de raccordement (105, 107) et le deuxième pôle de raccordement (113) de la deuxième borne de raccordement (111, 113) puisse être interrompue.

8. Module de raccordement électrique selon la revendication 5, 6 ou 7, dans lequel l'élément modulaire (109) peut être sorti du boîtier de module (101) par l'intermédiaire d'un trajet de poussée prédéterminé pour interrompre la liaison électrique entre les deuxièmes pôles de raccordement (107, 113).

9. Module de raccordement électrique selon la revendication 8, dans lequel le trajet de poussée prédéterminé est délimité par un élément d'encliquetage (340, 341).

10. Module de raccordement électrique selon l'une des revendications 2 à 4 précédentes, dans lequel le canal de test (143) est formé dans l'élément modulaire (109) et s'étend jusqu'au contact de serrage (131).

11. Module de raccordement électrique selon l'une des revendications 5 à 7 précédentes, dans lequel le canal de test (342) est formé dans le boîtier de module (301) et s'étend jusqu'au deuxième pôle de raccordement (305) de la première borne de raccordement (303, 305).

12. Module de raccordement électrique selon l'une des revendications précédentes, dans lequel la troisième borne de raccordement électrique (115, 117) est prévue pour recevoir de manière amovible, en particulier pour recevoir par complémentarité de force, des lignes électriques.

13. Module de raccordement électrique selon l'une des revendications précédentes, dans lequel les pôles de raccordement (115, 117) de la troisième borne de raccordement (115, 117) sont disposés les uns au-dessus des autres.

14. Procédé pour détecter une intensité de courant d'un courant électrique passant à travers le module de raccordement électrique selon l'une des revendications 1 à 13, **caractérisé par** :
l'interruption (701) d'une liaison électrique entre le deuxième pôle de raccordement de la première borne de raccordement et le deuxième pôle de raccordement de la troisième borne de raccordement,
l'établissement d'un contact électrique (703) avec le pôle de raccordement de la première borne de raccordement au moyen d'une première sonde de test guidée à travers le canal de test ;
l'établissement d'un contact électrique (703) avec le deuxième pôle de raccordement de la troisième borne de raccordement au moyen d'une deuxième sonde de test lorsqu'une liaison électrique est établie entre le premier pôle de raccordement de la première borne de raccordement et le premier pôle de raccordement de la troisième borne de raccordement ; et
la détection (707) de l'intensité du courant électrique passant entre la première sonde de test et la deuxième sonde de test.
